# EUROPEAN PATENT APPLICATION

(11) **EP 4 699 737 A1**
(43) Date of publication of application: **25.02.2026**
(21) Application number: 25159841.3
(22) Date of filing: 25.02.2025
(51) Int. Cl.: B23P 15/26, H05K 7/20

(54) **LIQUID DISPENSER AND MANUFACTURING METHOD THEREOF**

(30) Priority: 22.08.2024 CN 202411163370
(71) Applicant: Purple Cloud Development Pte. Ltd., Singapore 128424 (SG)
(72) Inventor: Liu, Weijiang, Hui Zhou City (CN); Tseng, Hsiang-Chieh, Taipei City (TW)
(74) Representative: Grünecker Patent- und Rechtsanwälte PartG mbB

(57) **Abstract**

A method for manufacturing a liquid dispenser includes machining a flow tube to form a manifold that includes a plurality of liquid dispensing holes and a plurality of fixing parts, performing precision processing on the liquid dispensing holes and the fixing parts to adjust dimensions thereof, performing a first cleaning process on the manifold, clamping the manifold in a jig at a clamping position of the manifold, welding a liquid inlet adapter and a liquid outlet adapter at opposite ends of the manifold, respectively, and performing a second cleaning process on the liquid dispenser, wherein the second cleaning process is simpler than the first cleaning process.

## Description

### TECHNICAL FIELD

The present disclosure relates to a liquid dispenser and a manufacturing method thereof, particularly a liquid dispenser suitable for the liquid cooling system of a server and a manufacturing method thereof.

### BACKGROUND OF THE INVENTION

Due to the rapid development of technology, server computing demands have increased. To reduce the heat during server operations, liquid cooling systems are employed to cool the various heat-generating electronic components. These electronic components are spread across multiple chassis within the server, requiring distribution pipes to be installed on the server rack for efficient delivery of the cooling liquid.

However, in the manufacturing of distribution pipes, the precision of the pipes is frequently diminished due to varying temperatures in the manufacturing environment, necessitating repeated processing to ensure the pipes fit the required dimensions. As a result, there is a critical need for R&D personnel to address the issue of providing a distribution pipe and a manufacturing method that can avoid the need for repeated processing, which leads to high manufacturing costs.

### SUMMARY

The present disclosure provides a new invented liquid dispenser and a method for manufacturing the liquid dispenser thereof, which eliminates the need for repetitive processing. The manufacturing method allows for meeting the required precision of the new dispenser while simultaneously reducing manufacturing costs.

The invention is as defined in the claims. In one embodiment of the present disclosure, a method for manufacturing a liquid dispenser includes machining a flow tube to form a manifold that includes a plurality of liquid dispensing holes and a plurality of fixing parts, performing precision processing on the liquid dispensing holes and the fixing parts to adjust dimensions thereof, performing a first cleaning process on the manifold, clamping the manifold in a jig at a clamping position of the manifold, welding a liquid inlet adapter and a liquid outlet adapter at opposite ends of the manifold, respectively, and performing a second cleaning process on the liquid dispenser, wherein the second cleaning process requires fewer steps and resources compared to the first cleaning process.

In one embodiment of the present disclosure, machining the flow tube to form the manifold can be performed by computer numerical control processing, waterjet processing, or cold drawing.

In one embodiment of the present disclosure, machining the flow tube to form the liquid dispensing holes and fixing parts in the manifold further comprises thinning a first sidewall of the flow tube to form a base surface on the first sidewall.

In one embodiment of the present disclosure, machining the flow tube to form the liquid dispensing holes and fixing parts in the manifold further comprises thinning a second sidewall of the flow tube and drilling holes in the second sidewall to form liquid dispensing holes.

In one embodiment of the present disclosure, machining the flow tube to form the liquid dispensing holes and fixing parts in the manifold further comprises thinning a third sidewall of the flow tube.

In one embodiment of the present disclosure, machining the flow tube to form the liquid dispensing holes and fixing parts in the manifold further comprises machining a fourth sidewall of the flow tube to form the fixing parts in a step-shape pattern therein.

In one embodiment of the present disclosure, the inlet adaptor and the outlet adaptor are welded at the opposite ends of the manifold by tungsten inert gas (ITG) welding or laser welding.

In one embodiment of the present disclosure, the clamping position portion is between the dispensing holes and the welding position.

In one embodiment of the present disclosure, the clamping position is between the welding position and a closest one of the fixing parts.

In one embodiment of the present disclosure, the fixing parts are mounted on a server chassis to secure the manifold to the server chassis.

In one embodiment of the present disclosure, a liquid dispenser for a liquid cooling system includes a manifold having a plurality of liquid dispensing holes and fixing parts, the liquid dispensing holes being connected to corresponding connectors, and the liquid dispensing holes and the fixing parts being arranged on different sides of the manifold, and an inlet adapter and an outlet adapter, each being welded to respective ends of the manifold, wherein the inlet adapter and the outlet adapter are in fluid communication with the manifold and are connected to an inlet pipe and an outlet pipe, respectively.

In one embodiment of the present disclosure, wherein the inlet adapter and the outlet adapter are welded to the respective ends of the manifold by tungsten inert gas (TIG) welding or laser welding.

In one embodiment of the present disclosure, the fixing parts are mounted on a server chassis to secure the manifold to the server chassis.

### BRIEF DESCRIPTION OF THE DRAWINGS

Aspects of the present disclosure can be understood from the following detailed description when reading with the accompanying Figures. It is noted that, in accordance with the standard practice in the industry, various features are not drawn to scale. In fact, the dimensions of the various features may be increased or reduced for clarity of discussion.
FIG. 1 is a flowchart illustrating a method for manufacturing a liquid dispenser according to an embodiment of the present invention.
FIG. 2 is a detailed flow chart of a specific step for the manufacturing process of the liquid dispenser of FIG. 1.
FIGS. 3-13 are schematic diagrams of the manufacturing process of the liquid dispenser shown in FIG. 1.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

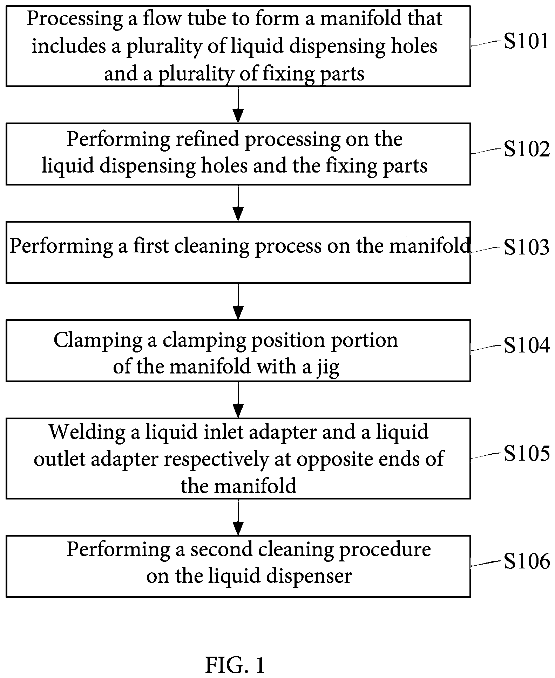

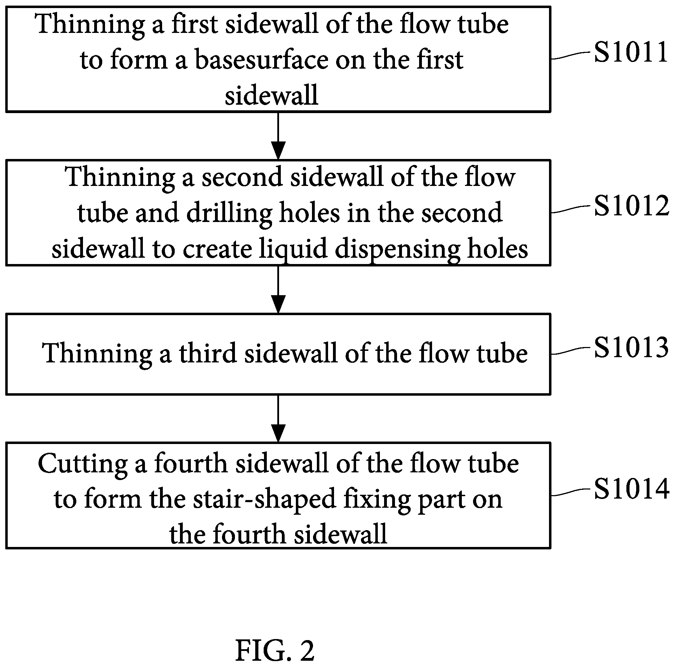

Referring to FIG. 1 and FIG. 2. FIG. 1 is a flowchart illustrating a method for manufacturing a liquid dispenser according to an embodiment of the present invention. FIG. 2 is a detailed flow chart of a specific step for the manufacturing process of the liquid dispenser of FIG. 1.

As illustrated in FIG. 1, the manufacturing method of a liquid dispenser includes the following steps, according to one embodiment of the present disclosure: Step S101, machining a flow tube to form a manifold that includes a plurality of liquid dispensing holes and a plurality of fixing parts; Step S102, performing refined processing on the liquid dispensing holes and the fixing parts; Step S103, performing a first cleaning process on the manifold; Step S104, clamping a clamping position portion of the manifold with a jig; Step S105, welding a liquid inlet adapter and a liquid outlet adapter respectively at opposite ends of the manifold; and Step S106, performing a second cleaning procedure on the liquid dispenser.

As illustrated in FIG. 2, Step S101 includes the following sub-steps: Step S1011, thinning a first sidewall of the flow tube to form a base surface on the first sidewall; Step S1012, thinning a second sidewall of the flow tube and drilling holes in the second sidewall to create liquid dispensing holes; Step S1013, thinning a third sidewall of the flow tube; and Step S1014, cutting a fourth sidewall of the flow tube to form the stair-shape fixing part on the fourth sidewall. According to one embodiment of the present disclosure, the sub-steps S1011 to S1014 in step S101 can be performed by at least one of the following methods: computer numerical control (CNC) processing, waterjet processing, or cold drawing (also referred to as cold extrusion or cold stretching), but the embodiment is not limited to these methods. In another embodiment, laser cutting can be applied to thin the sidewalls to guarantee high precision.

In one embodiment, Step S105 includes the following sub-step: Step S1051, welding the liquid inlet adapter and the liquid outlet adapter at opposite ends of the manifold via tungsten inert gas (TIG) welding or laser welding. The welding process is applied to the end of the manifold where precision is not compromised, eliminating the need for expensive large-scale vacuum brazing furnaces. As a result, this approach not only keeps the precision of the manifold but also improve production efficiency and lowers overall manufacturing costs.

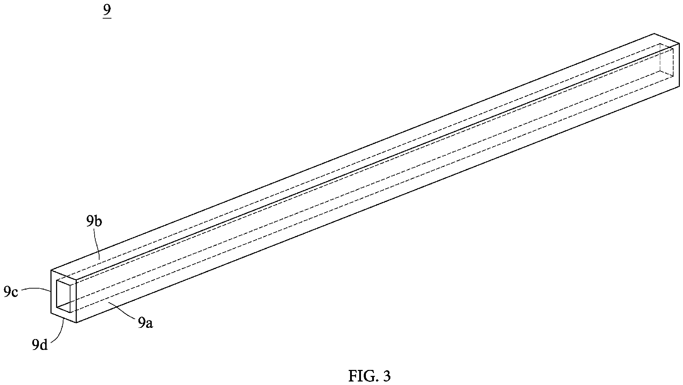

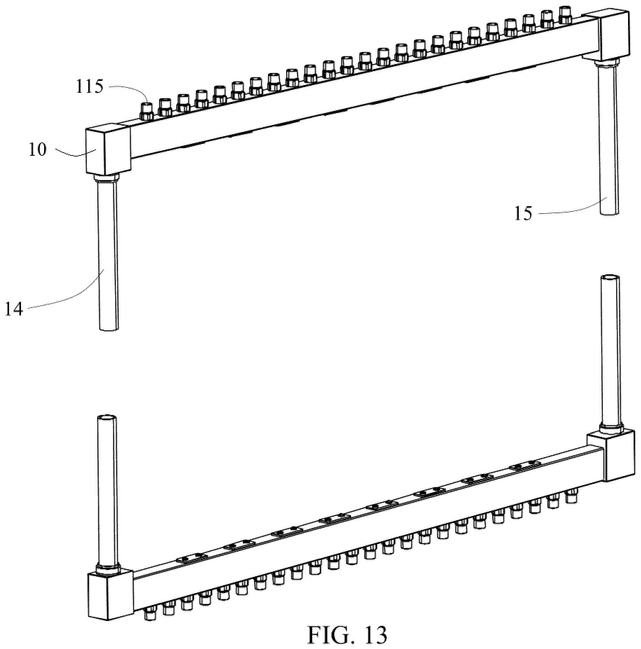

Referring to FIGS. 3-13 in conjunction with the above steps, wherein FIGS. 3-13 are schematic diagrams illustrating the manufacturing process of the liquid dispenser shown in FIG. 1.

As illustrated in FIGS. 3-4, flow tube 9 has a first sidewall 9a, a second sidewall 9b, a third sidewall 9c and a fourth sidewall 9d, which are sequentially connected to form the structure of the tube. In Step S101, the flow tube 9 is processed to form a manifold 11 that includes a plurality of liquid dispensing holes 111 and a plurality of fixing parts 112. The process transforms the flow tube into a functional manifold, ensuring proper fluid distribution and secure attachment capabilities.

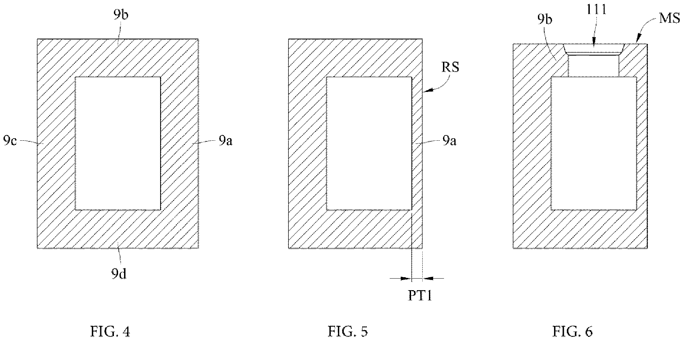

Specifically, in Step S1011, the first sidewall 9a of the flow tube is thinned. As illustrated in FIG.5, a reference surface RS is formed on the first thinned sidewall 9a. Further, the first thinned sidewall 9a has a first predetermined thickness PT₁ of at least 5 millimeters (mm) to ensure the structure strength of the final product.

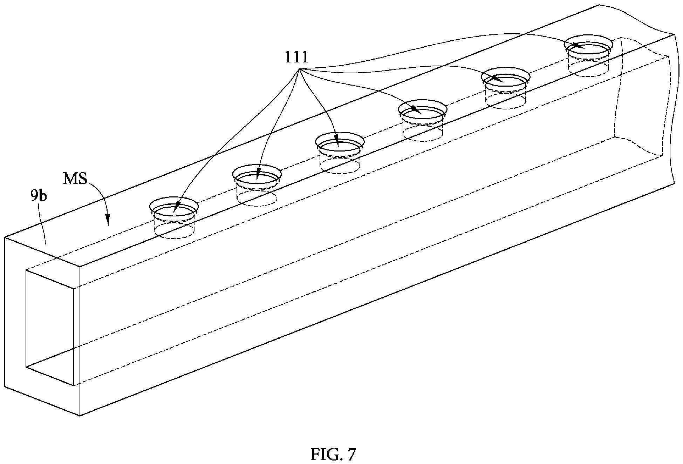

Next, in Step S1012, the second sidewall 9b of the flow tube 9 is thinned, and holes are drilled in the second sidewall 9b. As illustrated in Figures 6 and 7, the surface MS of the thinned second sidewall 9b can be used as a base for the drilling process. Furthermore, multiple liquid dispensing holes 111 are formed after the drilling, penetrating through the second sidewall 9b. The dispending holes 111 are configured to connect to corresponding connectors 115, ensuring proper fluid flow between the manifold 11 and external components.

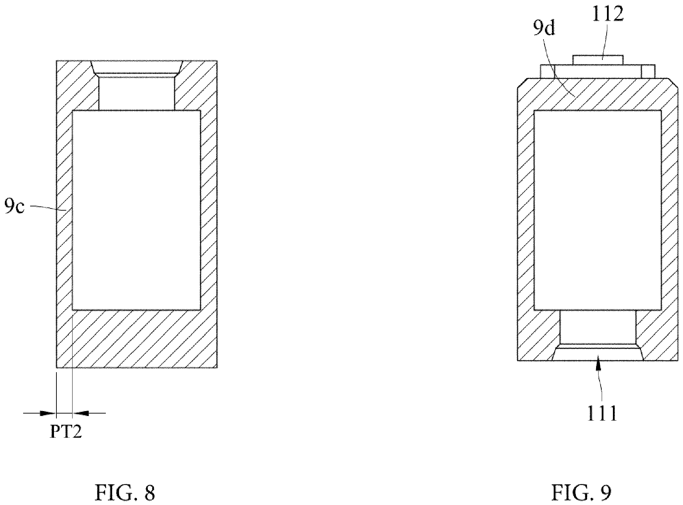

Subsequently, in Step S1013, the third sidewall 9c of the flow tube 9 is thinned. Similarly, the third thinned sidewall 9c has a second predetermined wall thickness PT₂ of at least 1 millimeters to ensure the structural integrity of the finished product, as illustrated in Figure 8.

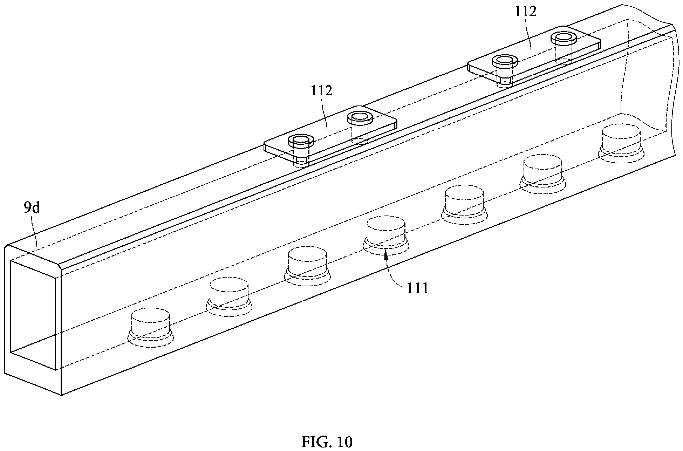

Following that, in Step S1014, the fourth sidewall 9d of the flow tube 9 is cut. As shown in Figures 9 and 10, the cutting of the fourth sidewall 9d results in the formation of multiple stair-shaped fixing parts 112, which are located on the opposite side of the dispensing holes 111. The fixing parts 112 are designed to secure the manifold 11 to the server chassis or similar components in other electronic system. It should be noted that the thickness of the sidewalls 9a through 9d may vary, and the embodiment of the present disclosure is not limited to a specific sidewall thickness for this invention.

Proceeding to Step S102, a fine processing is applied to the dispensing holes 111 and fixing parts 112 to improve their dimensional accuracy. Afterwards, in Step S103, a first cleaning process is applied to the manifold 11 to remove any process debris generated during the previous steps. For example, the first cleaning process is a thorough cleaning process designed to remove residues such as oils left by a previously performed CNC process.

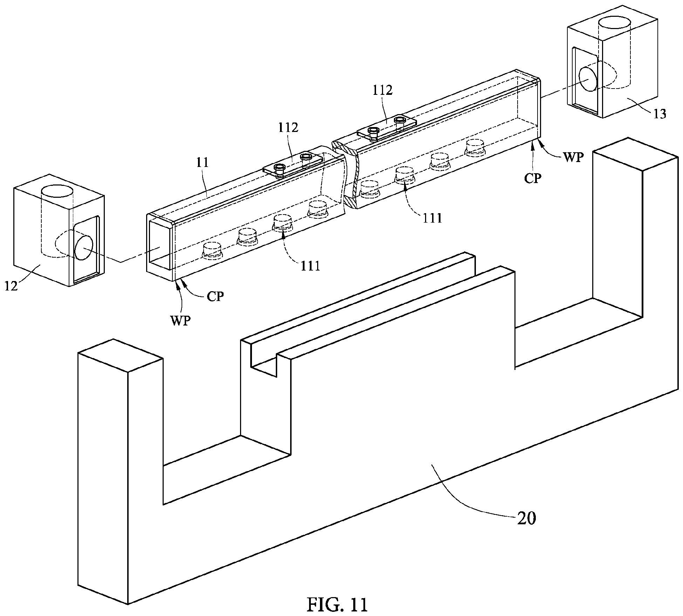

Continuing with Step S104, a jig 20 is used to clamp the manifold 11 at a clamping position portion CP, which is close to the ends of the manifold 11, facilitating the subsequent welding steps. Specifically, as shown in FIG. 11, the opposite ends of the manifold 11 are referred as the welding position portions WP. Each of the welding position portions WP is located further away from the dispensing holes 111 and fixing parts 112 than the clamping position portion CP. In other words, the clamping position CP can be positioned between the dispensing holes 111 and the welding positions WP, or between a closet one of the fixing parts 112 and the welding positions WP.

The design of the clamping position portion CP allows the heat generated at the welding position portions WP during the subsequent welding steps to be transmitted through the clamping position portion CP to the jig 20. Accordingly, the heat produced at the welding position portions WP is prevented from being transmitted to the dispensing holes 111 and fixing parts 112, thereby maintaining the accuracy of the processing on the dispensing holes 111 and fixing parts 112.

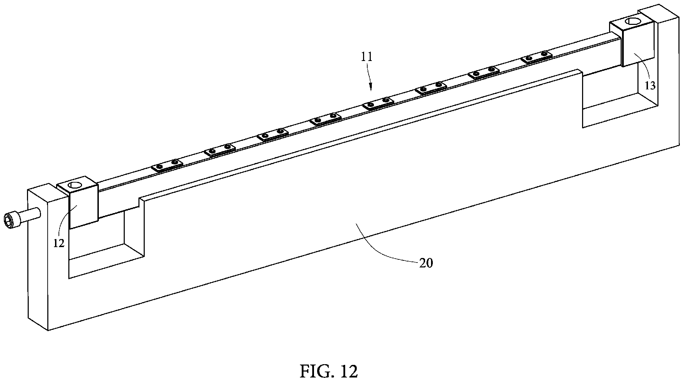

Next, in Step S105, an inlet adapter 12 and an outlet adapter 13 are respectively welded at the welding position portions WP on the opposite ends of the manifold 11. Specifically, in Step S105, the inlet adapter 12 and outlet adapter 13 are welded at the opposite ends of the manifold 11 through tungsten inert gas (TIG) welding or laser welding, as shown in FIGS. 11 and 12. After welding, both the inlet adapter 12 and outlet adapter 13 are in fluid communication with the manifold 11. By following the Step S101 to S105, the external structure of the liquid dispenser 10 is completed.

Subsequently, in Step S106, a second cleaning process is applied to the liquid dispenser 10. As no mechanical processing occurs in steps S104 to S105, no processing debris is generated. Therefore, the second cleaning process is only a simplified cleaning process, which requires fewer steps and resources compared to the first cleaning process.

The liquid dispenser 10 produced through the aforementioned steps utilizes both initial and refined processing to create dispensing holes 111 and fixing parts 112 with high precision. Further, the welding of the inlet adapter 12 and outlet adapter 13 is taken place at the welding position portions WP that are located further away from the dispensing holes 111 and fixing parts 112. Therefore, the precision of the dispensing holes 111 and fixing parts 112 is preserved after welding, avoiding the need for additional precision processing and thereby lowering manufacturing time and costs for the liquid dispenser 10.

Additionally, traditional methods rely on vacuum brazing to attach multiple spacers and adapter bases to the tubing. In contrast, the high-precision dispensing holes 111 and fixing parts 112 in this disclosure are formed through initial and refined processing, avoiding the need for expensive large vacuum brazing furnaces and improving production efficiency. This approach not only increases production capacity but also avoids the loss of precision in nearby welded spacers or adapter bases caused by high temperatures when welding them one at a time.

The completed liquid dispenser 10 can be mounted onto the rack (not shown) of a server via the fixing parts 112. The dispensing holes 111, inlet adapter 12, and outlet adapter 13 can be connected to multiple connectors 115, an inlet pipe 14, and an outlet pipe 15, respectively. The working fluid, delivered through the inlet pipe 14, is distributed by the liquid dispenser 10 to multiple connectors 115, flows through the server chassis, absorbs heat generated by the electronic components inside, and then exits through the outlet pipe 15, completing the heat exchange process. This system is suitable for liquid cooling systems in servers or any other similar electronic devices.

According to the embodiments above, both initial and fine processing are employed to create high precision dispensing holes 111 and fixing parts 112 of a liquid dispenser 10. The welding of the inlet adapter 12 and outlet adapter 13 is take place at positions away from the dispensing holes 111 and fixing parts 112. As a result, the precision of the dispensing holes 111 and fixing parts 112 is preserved after welding, avoiding the need for additional precision processing. Therefore, both the time and costs can be lowered in manufacturing the liquid dispenser.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. Of course, the disclosed embodiments are merely exemplary embodiments and that various modifications can be made without departing from the spirit and scope of the disclosure. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A method for manufacturing a liquid dispenser (10), comprising:
machining a flow tube (9) to form a manifold (11) that includes a plurality of liquid dispensing holes (111) and a plurality of fixing parts (112);
performing precision processing on the liquid dispensing holes (111) and the fixing parts (112) to adjust dimensions thereof;
performing a first cleaning process (S103) on the manifold (11);
clamping the manifold (11) in a jig (20) at a clamping position of the manifold (CP);
welding a liquid inlet adapter (12) and a liquid outlet adapter (13) at opposite ends of the manifold (11), respectively; and
performing a second cleaning process (S106) on the liquid dispenser (10), wherein the second cleaning process requires fewer steps and resources compared to the first cleaning process.

2. The method for manufacturing a liquid dispenser (10) of claim 1, wherein machining the flow tube (9) to form the manifold (11) can be performed by computer numerical control processing, waterjet processing, or cold drawing.

3. The method for manufacturing a liquid dispenser (10) of claim 1 or 2, wherein machining the flow tube (9) to form the liquid dispensing holes (111) and fixing parts (112) in the manifold (11) further comprises thinning a first sidewall (9a) of the flow tube (9) to form a base surface on the first sidewall (9a).

4. The method for manufacturing a liquid dispenser (10) of one of claims 1 to 3, wherein machining the flow tube (9) to form the liquid dispensing holes (111) and fixing parts (112) in the manifold (11) further comprises thinning a second sidewall (9b) of the flow tube (9) and drilling holes in the second sidewall (9b) to form liquid dispensing holes (111).

5. The method for manufacturing a liquid dispenser (10) of one of claims 1 to 4, wherein machining the flow tube (9) to form the liquid dispensing holes (111) and fixing parts (112) in the manifold (11) further comprises thinning a third sidewall (9c) of the flow tube (9).

6. The method for manufacturing a liquid dispenser (10) of one of claims 1 to 5, wherein machining the flow tube (9) to form the liquid dispensing holes (111) and fixing parts (112) in the manifold (11) further comprises machining a fourth sidewall (9d) of the flow tube (9) to form the fixing parts (112) in a step-shape pattern therein.

7. The method for manufacturing a liquid dispenser (10) of claim 3, wherein the thinned first sidewall (9a) has a first predetermined thickness (PT1) of at least 5 millimeters.

8. The method for manufacturing a liquid dispenser (10) of claim 5, wherein the thinned third sidewall (9c) has a second predetermined thickness (PT2) of at least 1 millimeters.

9. The method for manufacturing a liquid dispenser (10) of one of claims 1 to 5, wherein the inlet adaptor (12) and the outlet adaptor (13) are welded at the opposite ends of the manifold (11) by tungsten inert gas (ITG) welding or laser welding.

10. The method for manufacturing a liquid dispenser (10) of one of claims 1 to 9, wherein the clamping position portion (CP) is between the dispensing holes (111) and the welding position (WP).

11. The method for manufacturing a liquid dispenser (10) of one of claims 1 to 9, wherein the clamping position (CP) is between the welding position (WP) and a closest one of the fixing parts (112).

12. The method for manufacturing a liquid dispenser (10) of one of claims 1 to 11, wherein the fixing parts (112) are mounted on a server chassis to secure the manifold (11) to the server chassis.

13. A liquid dispenser (10) for a liquid cooling system, comprising:
a manifold (11) having a plurality of liquid dispensing holes (111) and fixing parts (112), the liquid dispensing holes (111) being connected to corresponding connectors (115), and the liquid dispensing holes (111) and the fixing parts (112) being arranged on different sides of the manifold (11); and
an inlet adapter (12) and an outlet adapter (13), each being welded to respective ends of the manifold (11), wherein the inlet adapter (12) and the outlet adapter (13) are in fluid communication with the manifold (11) and are connected to an inlet pipe (14) and an outlet pipe (15), respectively.

14. The liquid dispenser (10) of claim 14, wherein the inlet adapter (12) and the outlet adapter (13) are welded to the respective ends of the manifold (11) by tungsten inert gas (TIG) welding or laser welding.

15. The liquid dispenser (10) of claim 13 or 14, wherein the fixing parts (112) are mounted on a server chassis to secure the manifold (11) to the server chassis.
